(19) Europäisches Patentamt / European Patent Office / Office européen des brevets

(11) **EP 2 910 958 A1**

(12) **DEMANDE DE BREVET EUROPEEN**

(43) Date de publication:
**26.08.2015 Bulletin 2015/35**

(51) Int Cl.:
*G01R 31/02* [(2006.01)]    *H02H 3/46* [(2006.01)]
*G01R 23/15* [(2006.01)]

(21) Numéro de dépôt: **15152502.9**

(22) Date de dépôt: **26.01.2015**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **20.02.2014 FR 1451344**

(71) Demandeur: **Schneider Electric Industries SAS
92500 Rueil-Malmaison (FR)**

(72) Inventeurs:
• **Verneau, Guillaume
  38050 Grenoble (FR)**
• **Baumes, Nathalie
  38050 Grenoble (FR)**

(74) Mandataire: **Bié, Nicolas
  Schneider Electric Industries
  Propriete Industrielle
  World Trade Center 38EE1
  5 Place Robert Schuman
  38050 Grenoble Cedex 09 (FR)**

(54) **Détection d'un défaut, notamment transitoire, dans un réseau électrique**

(57) Afin de déterminer l'occurrence d'un défaut, notamment transitoire, dans un réseau de distribution électrique, un procédé et un dispositif sont développés en se basant sur la détermination de la fréquence (f) du signal de courant circulant dans une phase du réseau. Notamment, la différence entre la fréquence (f) déterminée et la fréquence propre ($f_0$) du réseau est comparée à un seuil.

**Fig. 3**

## Description

### DOMAINE TECHNIQUE

L'invention concerne la détection d'un défaut, par exemple à la terre, notamment dans un réseau aérien ; le procédé selon l'invention repose sur l'analyse de la fréquence du signal de courant.

Sous un autre aspect, l'invention concerne un dispositif de détection apte à mettre en oeuvre le procédé précédent. En particulier, le dispositif de détection de défaut comprend des moyens permettant de déterminer la fréquence du signal de courant à partir d'un nombre minimum de valeurs, notamment trois.

### ETAT DE LA TECHNIQUE

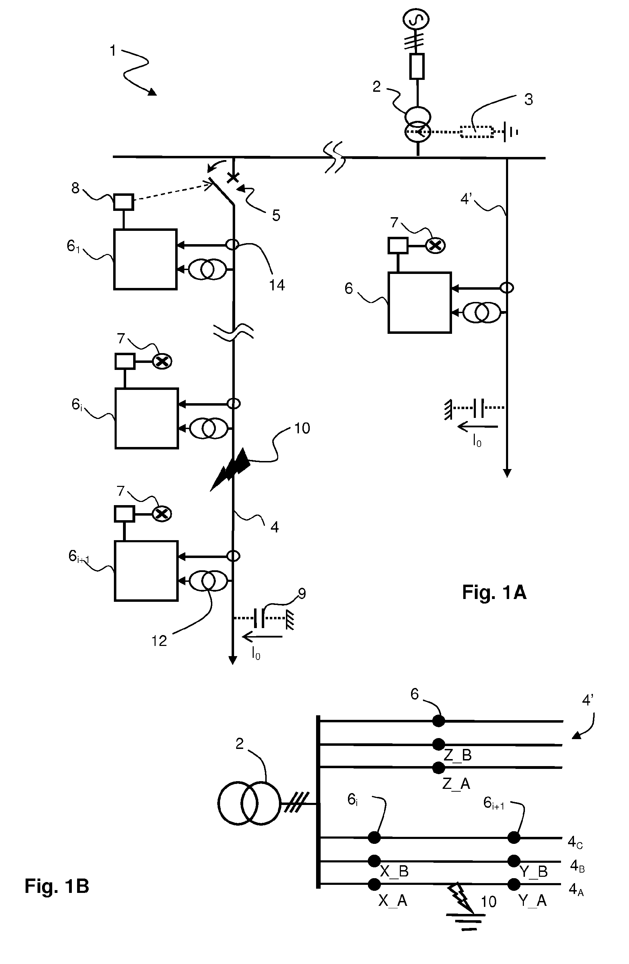

Les dispositifs de détection de défaut dans les réseaux triphasés permettent de déclencher la protection des charges et/ou d'aider à la localisation desdits défauts. Par exemple, la figure 1A représente un schéma d'un réseau 1 de distribution électrique moyenne tension qui comporte un transformateur 2 triphasé, dont le secondaire peut comporter un conducteur commun de neutre généralement connecté à la terre par une impédance 3 (dans le cas d'un réseau à neutre isolé, il n'existe pas de liaison physique entre le point neutre du réseau et la terre). Le secondaire est par ailleurs connecté à une ligne principale de distribution qui alimente des lignes de départ 4, 4', dont certaines peuvent comporter en tête un disjoncteur ou autre dispositif de coupure 5 les protégeant.

Les lignes de départ 4, 4', composées de lignes aériennes et/ou de câbles souterrains, peuvent être sujettes à des défauts variés, qu'il est important de détecter et localiser afin de pallier les problèmes générés : rupture d'alimentation, dégradation de la tenue des matériels d'isolation, sans compter la sécurité des personnes. Un dispositif de détection de défaut 6 installé sur les lignes de départ 4', ou des tronçons de ligne 4, peut servir d'indicateur de passage de défaut, allumant par exemple un voyant lumineux 7 ; un dispositif $6_1$ peut par ailleurs être associé ou intégré à un relai de protection 8 apte à commander l'ouverture des contacts du disjoncteur 5. Parmi ces défauts, les plus fréquents sont les défauts monophasés, de type court-circuit, localisés hors du poste source, dans lesquels une phase est en contact avec la terre, ou la rupture d'un câble aérien en cas d'intempérie notamment. Or, entre les conducteurs de ligne 4 et la terre peuvent apparaître des fortes valeurs de capacité 9, à l'origine de la circulation d'importants courants homopolaires $I_0$ en cas de défaut à la terre 10. Par ailleurs, les défauts sont de fait dans leur grande majorité non permanents, en particulier sur les réseaux aériens : certains disparaissent naturellement avant fonctionnement des protections, parfois de façon intermittente, d'autres sont éliminés par un cycle plus ou moins lent de ré-enclenchements,...

Pour prendre les éventuelles précautions nécessaires ou mettre en oeuvre les dispositifs adaptés de caractérisation et localisation du défaut, la détection des défauts doit être rapide, de l'ordre de quelques millisecondes, voire moins dans le cas de défauts transitoires, et bien entendu fiable.

Des dispositifs et procédés de détection de défaut existent, comme décrit par exemple dans EP 1 475 874, EP 1 890 165, FR 2 936 319, FR 2 936 378 ou WO 2006/136520. Ils sont pour la plupart basés sur le franchissement d'un seuil par un paramètre mesuré ou calculé : outre la mesure du courant ou de la tension, ainsi que de grandeurs en dérivant (moyenne,...), les composantes temporelles ou symétriques, voire les phaseurs, sont utilisées ; pour les défauts aériens, des mesures de champ magnétique ou électrique sur poteau ou par ligne sont aussi proposées. Cependant, l'efficacité des alertes de dépassement de seuil dépend fortement des paramètres du réseau comme le régime de neutre ou la résistivité du sol, ainsi que des technologies des capteurs. De plus, certaines techniques nécessitent un échantillonnage important ou une durée de calcul ne permettant la détection du défaut que lors de la période suivante du courant, voire pas du tout pour les événements transitoires.

### EXPOSE DE L'INVENTION

Parmi autres avantages, l'invention vise à pallier des inconvénients des dispositifs et procédés de détection de défaut existants, et à optimiser la détection de défaut.

En particulier, le principe de détection selon l'invention repose sur la détermination de la fréquence d'une grandeur électrique, par exemple du courant circulant, dans le réseau et sa comparaison à la fréquence propre.

Sous un de ses aspects, l'invention est relative à un procédé de détection de l'occurrence d'un défaut, y compris transitoire, dans un réseau multiphasé, comprenant l'obtention de signaux représentatifs d'un paramètre du courant, notamment une tension de phase, sur au moins une durée prédéterminée. De préférence, les signaux sont filtrés et/ou échantillonnés. Le procédé comprend ensuite une étape de détermination de la fréquence du signal présumé sinusoïdal sur la base des signaux obtenus, et notamment par approximation polynomiale dudit signal et résolution de l'équation à partir de trois valeurs consécutives du paramètre espacées de la même durée ; avantageusement, la fréquence est déterminée par l'intermédiaire de sa variation par rapport à la fréquence propre du réseau.

De préférence, le procédé selon l'invention comprend une étape de stockage des valeurs du paramètre pendant une durée du stockage, supérieure à la durée de calcul, lesdites valeurs du paramètre pouvant être associées à la fréquence déterminée correspondante.

La fréquence déterminée est ensuite comparée à des seuils pour vérifier qu'elle reste comprise entre deux valeurs, de préférence centrées sur la fréquence propre du réseau. Selon le résultat, l'occurrence d'un défaut est identifiée ou non. Le procédé comprend alors de préférence la transmission de l'information relative à la présence du défaut, et éventuellement également les données stockées, à un bloc de contrôle/commande par exemple.

L'invention a par ailleurs pour objet un dispositif de détection de défaut, adapté pour un réseau multiphasé, et notamment lorsque le réseau est à neutre compensé ou isolé. Le dispositif de détection selon l'invention peut être associé à des capteurs de courant et/ou de tension qui lui fournissent les signaux représentatifs correspondants.

Le dispositif selon l'invention comprend un premier module apte à fournir un signal représentatif d'un paramètre du réseau ; de préférence, le premier module comprend des moyens pour recevoir le signal représentatif du paramètre, notamment une tension de phase, des moyens d'échantillonnage et/ou des moyens de filtrage comme un filtre analogique. Le premier module comprend des moyens pour stocker le signal sur une durée prédéterminée.

Le dispositif selon l'invention comprend un deuxième module de traitement apte à déterminer la fréquence du signal à partir de valeurs stockées du paramètre, de préférence à partir de trois valeurs espacées d'une durée identique d'échantillonnage. Avantageusement, les moyens pour déterminer la fréquence sont adaptés pour la résolution d'approximations polynomiales d'un signal sinusoïdal. Le module de traitement comprend en outre des moyens pour vérifier que la fréquence ainsi déterminée est comprise dans une bande de préférence centrée sur la fréquence propre du réseau, qui peut être un paramètre ajustable du dispositif.

Avantageusement, le dispositif comprend également des moyens pour communiquer l'information relative au résultat de la comparaison, c'est-à-dire à l'occurrence d'un défaut, ainsi qu'éventuellement certaines des données stockées du paramètre.

Dans un mode de réalisation préféré, le dispositif de détection comprend en outre des moyens pour fournir un signal représentatif d'un deuxième paramètre du réseau simultané au paramètre précédent, les moyens de stockage étant adaptés pour le conserver en mémoire également, par paire.

Le dispositif de détection selon l'invention peut être triplé, avec un dispositif par phase, pour former un appareil de détection de défaut sur une ligne, par exemple aérienne, les moyens de communication étant adaptés pour envoyer leurs informations au même bloc de commande.

**BREVE DESCRIPTION DES FIGURES**

D'autres avantages et caractéristiques ressortiront plus clairement de la description qui suit de modes particuliers de réalisation de l'invention, donnés à titre illustratif et nullement limitatifs, représentés dans les figures annexées.

La figure 1A, déjà décrite, représente un réseau électrique dans lequel des dispositifs de détection de défaut peuvent être utilisés ; la figure 1B montre plus précisément les localisations des mesures possibles pour la détection selon l'invention.

La figure 2A montre de façon schématique et filtrée des signaux représentatifs des courants de phase et homopolaires, ainsi que leur fréquence, lors de l'apparition d'un défaut à la terre à l'aval et à l'amont du dispositif de détection ; la figure 2B illustre le cas particulier du défaut transitoire ; la figure 2C montre les signaux de courant, tension et fréquence sur un départ sain lors de l'apparition d'un défaut dans le réseau.

La figure 3 illustre le procédé de détection selon un mode de réalisation préféré de l'invention.

La figure 4 représente un schéma bloc d'un dispositif de détection selon un mode de réalisation préféré de l'invention.

**DESCRIPTION DETAILLEE D'UN MODE DE REALISATION PREFERE**

L'invention sera décrite pour un réseau triphasé équilibré 1 à neutre compensé ou isolé, dans lequel chaque ligne 4, 4' comprend trois conducteurs de phase $4_A$, $4_B$, $4_C$ aériens, le secondaire du transformateur 2 est relié à la terre par une bobine de Petersen 3 (figure 1A), ou n'y étant pas relié (figure 1B), et le courant homopolaire $I_0$ est nul en l'absence de défaut. Par courant homopolaire $I_0$ (ou « *zero sequence currrent* » selon la terminologie anglo-saxonne), on entend, à un éventuel facteur trois près, la sommation vectorielle des différents courants de phase, ou encore le courant correspondant à la résultante instantanée des courants de phase, parfois appelé courant résiduel, qui correspond éventuellement au courant de défaut à la terre (« *ground default currrent* » selon la terminologie anglo-saxonne) ou au courant de fuite. Il est à noter qu'il est possible de s'écarter de cette situation, avec notamment un courant/une tension homopolaire non nul, et le réseau peut comprendre un autre nombre de phases ; par ailleurs, le régime de neutre peut ne pas être compensé.

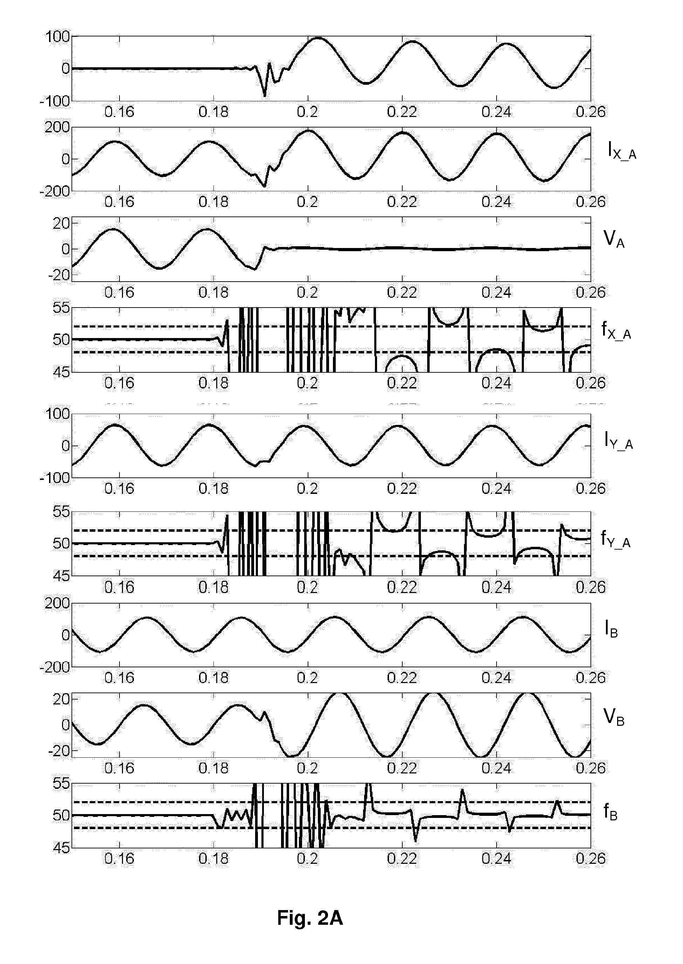

Tel qu'il est connu, lors de l'apparition d'un défaut à la terre 10 sur une des phases A, le courant $I_A$ de ladite phase voit son amplitude augmenter en amont ($I_{X\_A}$) du défaut 10 : il y a donc apparition d'un courant homopolaire $I_0$ en amont du défaut 10. Tel qu'illustré en figure 2A, on note en outre l'augmentation fréquente d'un courant $I_{Y\_A}$ également en aval du défaut par liaison capacitive 9 ; par ailleurs, des altérations $I_B$ peuvent également être présentes sur les phases non en défaut, mais leur amplitude est faible. Enfin, bien entendu, la tension $V_A$, $V_B$ présente sur les différentes phases est elle aussi affectée, de façon plus ou moins détectable.

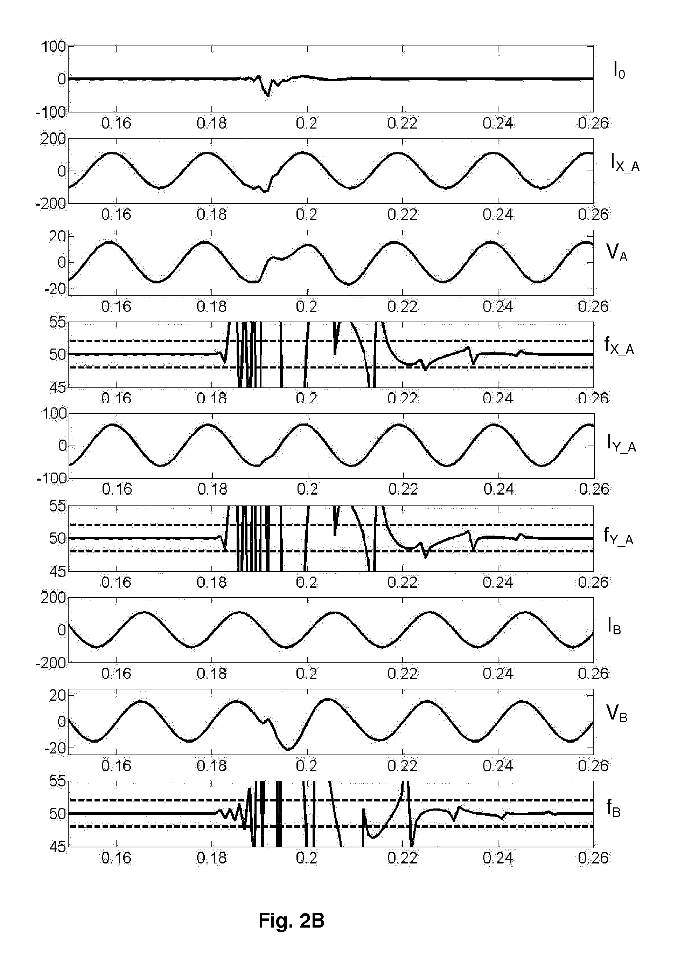

Lorsque le défaut est transitoire, comme illustré en figure 2B pour un défaut terre de résistance 1 Ω fugitif d'une durée de 1 ms sur un réseau aérien à neutre compensé, les mêmes phénomènes surviennent, mais sur une durée réduite : l'amplitude des modifications du courant et de la tension $V_A$, $V_B$ peut ainsi être noyée dans le bruit du signal proprement dit, et devenir quasi-invisible pour certains dispositifs de mesure. Par ailleurs, même pour les signaux comme le courant homopolaire $I_0$ dont l'amplitude de la modification est plus notable, la durée durant laquelle le signal est modifié, bien que souvent légèrement supérieure à la durée du défaut 10 du fait de la décharge des courants capacitifs, reste faible, et peut être insuffisante pour permettre un échantillonnage nécessaire aux procédés de détection de défaut basés sur un calcul de la modification d'un signal.

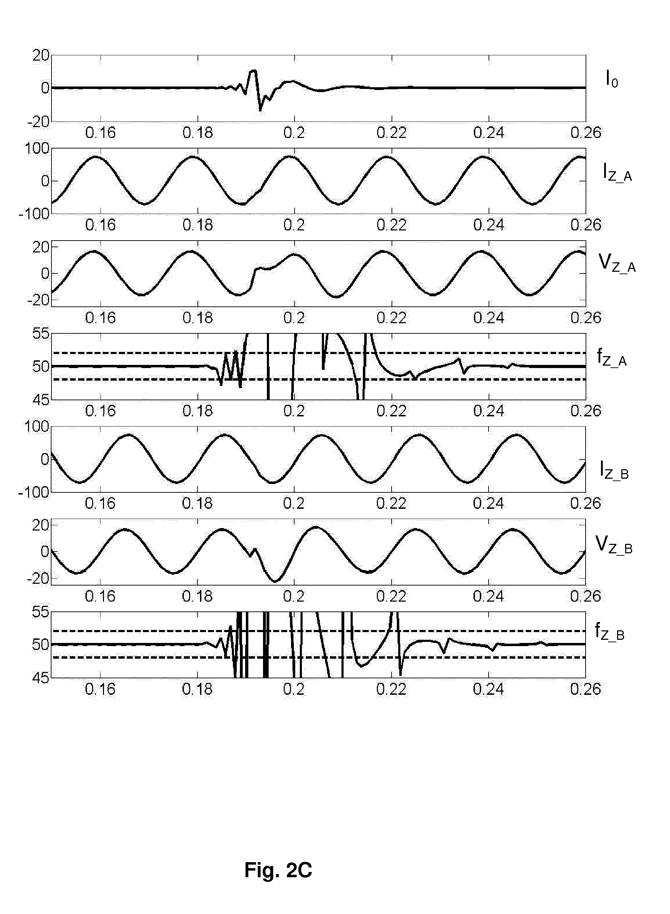

On note cependant sur la figure 2B que, quel que soit le point de mesure, en amont X_A ou en aval Y_A du défaut 10, mais aussi sur une phase saine B, la fréquence f du courant dans le réseau 1 quant à elle est fortement perturbée pendant le défaut. Cette modification de la fréquence, calculée depuis les courbes de courant et/ou de tension, est bien entendu également présente pour un défaut non transitoire, tel qu'illustré en figure 2A. Qui plus est, on constate sur la figure 2C que, même pour un défaut transitoire et même pour une mesure sur un départ sain 4', le défaut 10 génère une altération notable de la fréquence $f_{Z\_A}$, $f_{Z\_B}$ du courant.

Les inventeurs ont ainsi pris note que la présence d'une altération de la fréquence, et la sortie de cette dernière de limites encadrant la bande autorisée, à savoir 50 ± 0,5 Hz en France métropolitaine, permet d'identifier la présence d'un défaut sur le réseau. Un exemple de limites est représenté par deux traits pointillés localisés à 48 et 52 Hz sur les figures 2.

Cependant, la détermination de la fréquence utilise, en particulier dans le domaine du monitorage de réseau électrique, des calculs longs, qui impliquent une réactivité différée et un risque d'aveuglement du défaut fugitif dans le signal sain. En particulier, les détections de passages par zéro, par un maximum ou par un minimum du signal requièrent une durée de mesure au moins égale à une période de réseau, tout comme les phaseurs. Or, tel qu'expliqué plus haut, l'invention cherche à identifier la présence d'un défaut très rapidement, en temps réel, et ce y compris pour des défauts transitoires très courts.

Malgré cet état de fait, l'invention utilise ce paramètre pour un procédé et un dispositif de détection de défaut. De fait, les inventeurs ont trouvé que certaines techniques analytiques, notamment la résolution de polynômes, peuvent permettre d'appliquer leurs constatations en ne disposant de mesures du signal que sur une durée réduite, notamment seulement sur trois points.

En particulier, la détermination de la fréquence d'un signal sinusoïdal $Y(t) = A \times \sin (2 \cdot \pi \cdot f \cdot t + \varphi)$ peut être réalisée à partir de seulement trois mesures du signal, notamment de la tension, $V_k$ successives espacées du même intervalle de temps $T_{ech}$ en arrivant à l'équation suivante : $\cos (2 \cdot n \cdot f \cdot T_{ech}) = (V_{k-1} + V_{k+1}) / V_k$, c'est-à-dire que la fréquence f du signal de tension V est donnée par :

$$f = \frac{\text{Arc} \cos \left( \frac{V_{k-1} + V_{k+1}}{V_k} \right)}{2 \cdot \pi \cdot T_{ech}}$$

Bien entendu, cette méthode est limitée aux échantillons pour lesquels le signal de tension ne passe pas par zéro : on note les pics sur certaines courbes de fréquence calculées sur les figures 2 correspondant à ces échantillons.

Comme la fonction arc cosinus peut requérir des moyens de calcul importants, ainsi qu'un temps relativement long avant de fournir le résultat, selon un mode de réalisation préféré de l'invention, la fréquence f du signal V est évaluée par l'intermédiaire des développements limités au voisinage de zéro, la précision s'avérant de fait suffisante pour le résultat attendu. En particulier, on a pour les fonctions sinus et cosinus :

$$\cos(x) = 1 - \frac{x^2}{2} + \frac{x^4}{24} + o(x^4) \qquad \text{et}$$

$$\sin(x) = x - \frac{x^3}{6} + o(x^4)$$

En connaissant trois valeurs successives du paramètre, espacées du même intervalle, il est ainsi possible, par la résolution d'un polynôme, de déterminer une approximation de la fréquence f du signal. Alternativement, en considérant la variation de fréquence par rapport à la fréquence propre uniquement, c'est-à-dire $\delta f = f - f_0$, on peut également considérer des polynômes d'ordre 1, 2, 3 ou 4. En particulier, la détermination d'une estimation de la variation de la fréquence $\delta f$ peut être faite via la résolution de l'un des polynômes suivants :

1- $(V_{k-1} + V_{k+1})/V_k = a - b \cdot X$
2- $(V_{k-1} + V_{k+1})/V_k = a - b \cdot X - a/2 \cdot X^2$
3- $(V_{k-1} + V_{k+1})/V_k = a - b \cdot X - a/2 \cdot X^2 + b/6 \cdot X^3$
4- $(V_{k-1} + V_{k+1})/V_k = a - b \cdot X - a/2 \cdot X^2 + b/6 \cdot X^3 + a/24 \cdot X^4$

avec $X = 2 \cdot \pi \cdot \delta f \cdot T_{ech}$ ; $a = \cos (2 \cdot \pi \cdot f_0 \cdot T_{ech})$ ; $b = \sin (2 \cdot \pi \cdot f_0 \cdot T_{ech})$

Des méthodes mathématiques analytiques sont connues pour résoudre ce type de polynôme, notamment :

- la méthode dite de Viete pour l'équation 2- et l'ordre quadratique ;

- les méthodes dites de Cardan ou Tartaglia pour l'équation 3- et l'ordre cubique ;
- les méthodes de Descartes ou Ferrari pour l'équation 4- et l'ordre quartique.

Le choix de l'ordre du polynôme utilisé selon l'invention est de fait l'objet d'un compromis entre :

- les fonctionnalités du produit final : un simple détecteur de défaut peut parfois se contenter de l'ordre 1 ou 2 ; si par contre la fréquence f est elle aussi utilisée pour certaines fonctions de monitoring en l'absence de défaut 10 sur le réseau 1 (calcul de puissance, d'énergie, d'harmoniques, de qualimétrie...), un ordre polynomial supérieur est préconisé ;
- l'échantillonnage $T_{ech}$ choisi, qui doit dans tous les cas est supérieur au tiers de celui de la fréquence de Shannon (si l'application requiert d'aller jusque 150 HZ, c'est-à-dire un échantillonnage supérieur à 300 Hz selon le théorème de Nyquist-Shannon, l'échantillonnage $T_{ech}$ selon l'invention est supérieur à 450 Hz) ;
- les performances du microprocesseur, qui doit pouvoir effectuer le calcul entre deux échantillons séparés de $T_{ech}$. En particulier, on peut estimer le temps de calcul à moins de 11 $\mu$s pour un polynôme d'ordre 1, environ 12,5 $\mu$s pour un polynôme d'ordre 2, environ 155 $\mu$s pour un polynôme d'ordre 3 et 186 $\mu$s pour un polynôme d'ordre 4 avec un processeur Intel Core Duo P8700 à 2,33 GHz.

Pour des applications de détection de défaut par sortie de la bande de fréquence [48-52 Hz], on constate de fait que même un échantillonnage faible (typiquement 1800 Hz) peut largement convenir : le pas d'échantillonnage $T_{ech}$ = 0,556 ms laisse largement le temps de réaliser n'importe lequel des quatre calculs précédents. Le mode de réalisation préféré selon l'invention utilise ainsi un ordre polynomial OP = 3 pour un échantillonnage de 1800 Hz.

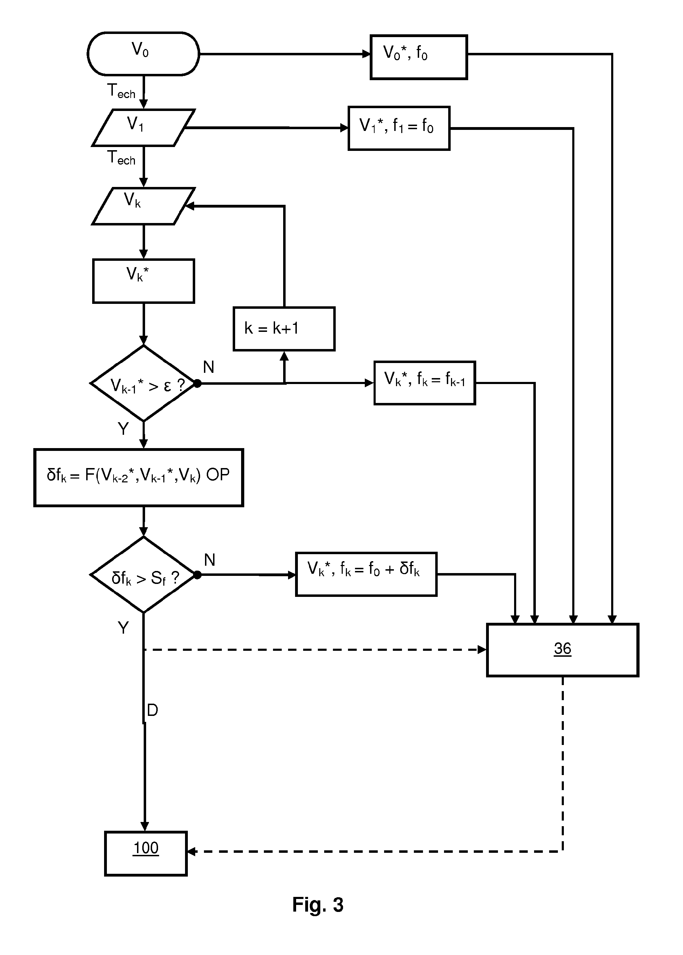

Ainsi, tel qu'illustré en figure 3, un procédé de détection de défaut selon un mode de réalisation préféré de l'invention comprend les étapes successives de :

- obtention de signaux représentatifs de la tension V dans une phase du réseau espacés d'une durée prédéterminée $T_{ech}$ ; de préférence, les signaux sont obtenus par mesure continue avec échantillonnage et filtrage;
- détermination de la variation de fréquence $\delta f$ - par un calcul mathématique prédéfini de résolution d'un polynôme d'ordre OP fixé et correspondant à l'une des formules précédentes, notamment à l'équation 3- ;
- comparaison de la variation de fréquence $\delta f$ à un seuil $S_f$ afin d'identifier l'occurrence d'un défaut 10.

Selon une alternative préférée, il est possible de changer le polynôme, c'est-à-dire l'ordre polynomial OP en fonction de la gestion de l'atelier d'énergie et de la consommation.

Dans un mode de réalisation préféré, pour éviter une division par un signal trop faible (on utilise le paramètre $(V_{k-1} + V_{k+1}) / V_k$, correspondant aux pics visibles sur les figures 2), la valeur centrale des trois signaux de tension obtenus est comparée à un seuil $\varepsilon$. Si cet échantillon $V_k$ est de fait trop petit, par exemple inférieur à 0,2 % de la tension nominale du réseau 1, alors la variation de fréquence $\delta f$ est considérée comme nulle ($f = f_0$) ou identique à la précédente ($f_k = f_{k-1}$) et le procédé de détermination est reporté de $T_{ech}$.

Une fois le défaut détecté, un simple signal d'alerte 7 peut être émis, ou inversement un relai de protection 8 peut être déclenché automatiquement ; différentes autres options sont possibles. Selon un mode de réalisation préféré, une centrale de commande 100 est notifiée du défaut, afin qu'une étape d'évaluation de la situation soit mise en oeuvre; en particulier, les paramètres mesurés et calculés dans le procédé de détection peuvent avoir été stockés et transmis conjointement à l'indication de la détection d'un défaut afin de procéder par exemple à la localisation du défaut, notamment selon le principe présenté dans FR 2 713 411, et/ou à la détermination de sa nature, notamment selon le principe présenté dans FR 2 959 618.

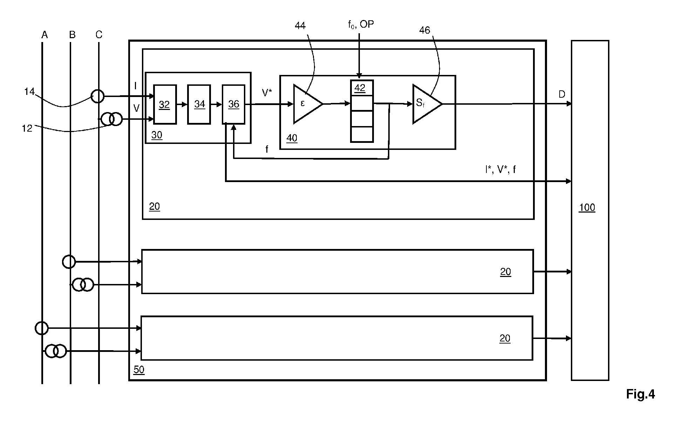

Un dispositif 20 permettant de mettre en oeuvre le procédé selon l'invention est illustré en figure 4. Le dispositif comprend un premier module 30 permettant d'obtenir un signal représentatif du courant, notamment la tension V, à partir d'informations fournies par un capteur de tension 12 adapté ; le dispositif selon l'invention peut être couplé au capteur 12 par liaison ou peut être directement mis en place sur le câble d'un réseau aérien. Le premier module 30 comprend de préférence, dans un ordre indifférencié, des moyens 32 de filtrage du signal V comme un filtre analogique et des moyens 34 d'échantillonnage, fonctionnant notamment à 1800 Hz ; le signal échantillonné filtré V* est stocké, par exemple de manière glissante et uniquement pendant $3T_{ech}$ ou pendant une durée $T_{stock}$ déterminée dans des moyens de stockage 36.

Le dispositif 20 selon l'invention comprend ensuite un deuxième module 40 de vérification de la fréquence f. Le premier module 30 fournit trois valeurs consécutives $V_{k-1}$, $V_k$, $V_{k+1}$ de la tension à des moyens de calcul 42 du deuxième module 40, aptes à calculer la fréquence du signal par résolution polynomiale sur la base des trois valeurs de tension $V_{k-1}$, $V_b$ $V_{k+1}$. Dans un mode de réalisation avantageux, les moyens de calculs comprennent plusieurs blocs, chacun utilisant un modèle de résolution OP d'ordre différent, et les moyens de calcul 42 sont dotés de moyens de sélection du bloc qui sera en action ; les mêmes moyens de sélection permettent avantageusement de rentrer la fréquence propre $f_0$ du réseau 1 sur lequel le dispositif 20 sera installé.

De préférence, le deuxième module 40 comprend préalablement des moyens 44 pour comparer la valeur centrale $V_k$ à un seuil $\varepsilon$, et pour activer les moyens de calcul 42 lorsque le signal est suffisamment grand. Le deuxième module 40 comprend enfin des moyens 46 pour comparer la fréquence calculée f à un seuil $f_0 \pm S_f$, et des moyens pour communiquer l'information quant à la détection D d'un défaut par dépassement du seuil. Outre l'indication de l'occurrence d'un défaut, les moyens de communication peuvent être adaptés pour communiquer à un bloc de commande également les valeurs stockées dans les moyens de stockage 36.

Dans un mode de réalisation avantageux, le dispositif 20 selon l'invention est adapté pour également obtenir et stocker des signaux représentatifs d'un autre paramètre, notamment le courant I mesuré par un capteur adapté 14, les signaux étant échantillonnés et filtrés par le même premier module 30 et stockés par paires avec les signaux de tension V*, pour être communiqués conjointement.

Un appareil de détection 50 comprend avantageusement trois dispositifs 20 selon l'invention, un par phase, les trois dispositifs 20 communiquant vers le même bloc de commande 100.

Ainsi, grâce à l'utilisation de la fréquence f comme paramètre d'identification de l'occurrence d'un défaut 10, il est possible d'assurer, y compris pour les réseaux aériens 1, la détection rapide et simultanée d'un défaut 10 de nature non permanente (c'est-à-dire de très courte durée, jusque 1 ms), sans connaissance préalable du réseau 1 autre que sa fréquence propre $f_0$. Bien qu'elle puisse être simultanée sur les différentes phases, la détection est indépendante des phases A, B, C : le problème de l'aveuglement par rapport aux autres phases est levé.

Ainsi, l'occurrence du défaut 10 peut être identifiée y compris par mesure sur une phase B différente de celle A où il se produit, y compris sur un départ 4' différent de celui 4 où est réalisée la mesure, sans liaison ni communication entre les capteurs 12, 14 des différentes phases. En outre, aucun réglage de seuil n'est nécessaire : le procédé et le dispositif selon l'invention peuvent être utilisés directement en indiquant la fréquence nominale $f_0$ du réseau électrique pluriphasé concerné (50 Hz ou 60 Hz, voire 400 Hz pour un réseau embarqué de type avion ou bateau) ; il n'est pas requis de connaître la tension nominale du réseau 1, le courant de charge nominal, le courant de défaut attendu ou le courant capacitif de réseau.

Par ailleurs, la mise en oeuvre de la détection de défaut peut être réalisée à partir de trois échantillons seulement, ce qui permet une bonne réactivité de la détection, y compris pour un défaut non permanent de très courte durée, notamment dans le mode de réalisation préféré dans lequel la fréquence est déterminée par résolution analytique de polynômes d'ordre 1 à 4 selon les méthodes dites de Viete (pour l'ordre quadratique), de Cardan ou Tartaglia (pour l'ordre cubique), de Descartes ou Ferrari (pour l'ordre quartique).

Grâce à cette détermination rapide de fréquence, il est possible de réagir plus rapidement face à ces dysfonctionnements, en comparaison des méthodes classiques.

Bien que l'invention ait été décrite avec l'utilisation de la tension sur une phase, elle ne s'y limite pas : il est possible de procéder à la détection par détermination de la fréquence f à partir du courant I, notamment lorsque les lignes 4 ne sont pas faiblement chargées (pour éviter tout problème dans la mesure). De même, les caractéristiques du réseau 1 peuvent être variées, le régime de neutre notamment étant indifférent, ainsi que le nombre de phases ou la fréquence propre $f_0$. Par ailleurs, le principe de détermination de la fréquence peut bien entendu être associé à d'autres applications, comme dans les relais de protection ou les qualimètres, ou pour éviter tout risque d'ilotage dans les productions décentralisées de type photovoltaïque ou éolien.

**Revendications**

1. Procédé de détection d'un défaut (10) sur un réseau électrique (1) d'une fréquence propre ($f_0$) comprenant :

   - l'obtention d'un signal représentatif d'un paramètre du courant (V) dans le réseau (1) sur au moins deux fois une durée prédéterminée ($T_{ech}$) ;
   - la détermination de la fréquence (f) du signal représentatif obtenu, ledit signal (V) étant considéré comme sinusoïdal ;
   - la vérification que la fréquence déterminée (f) est comprise entre un premier et un deuxième seuil ;
   - l'identification de la présence d'un défaut (10) si la vérification précédente n'est pas remplie.

2. Procédé de détection d'un défaut selon la revendication 1 dans lequel le premier, respectivement deuxième, seuil est fixé par la fréquence propre ($f_0$) du réseau (1) à laquelle est ajoutée, respectivement retirée, une marge ($S_f$).

3. Procédé de détection d'un défaut selon l'une des revendications 1 ou 2 dans lequel la détermination de la fréquence est réalisée par la détermination de la variation de la fréquence ($\delta f$) par rapport à la fréquence propre ($f_0$).

4. Procédé de détection d'un défaut selon l'une des revendications 1 à 3 dans lequel l'obtention du signal représentatif (V) comprend l'obtention de trois valeurs consécutives du signal représentatif, espacées de la durée prédéterminée ($T_{ech}$).

**5.** Procédé de détection d'un défaut selon la revendication 4 dans lequel la détermination de la fréquence est réalisée par approximation polynomiale de la sinusoïde du signal.

**6.** Procédé de détection d'un défaut selon l'une des revendications 1 à 5 comprenant en outre le stockage des signaux représentatifs du paramètre (V) obtenus pendant une durée de stockage ($T_{stock}$).

**7.** Procédé de détection d'un défaut selon la revendication 6 comprenant la transmission des valeurs stockées si un défaut est identifié.

**8.** Dispositif (20) de détection d'un défaut (10) dans un réseau (1) ayant une fréquence propre ($f_0$) comportant :

    - un premier module (30) pour fournir un premier paramètre (V) représentatif du courant circulant dans le réseau comprenant des moyens de réception (32, 34) d'un signal représentatif dudit premier paramètre et des moyens (36) pour stocker le signal représentatif sur au moins une durée prédéterminée ($2 \cdot T_{ech}$) ;
    - un deuxième module de détection comprenant des moyens (42) de calcul de la fréquence (f) du signal à partir des valeurs du premier paramètre sur la durée prédéterminée ($2 \cdot T_{ech}$) et des moyens de comparaison (46) pour comparer la fréquence (f) déterminée à un seuil.

**9.** Dispositif de détection d'un défaut selon la revendication 8 dans lequel le premier module (30) est adapté pour stocker des premiers paramètres à intervalles prédéterminés ($T_{ech}$), et les moyens (42) de calcul du deuxième module sont adaptés pour calculer la fréquence (f) à partir de trois premiers paramètres consécutifs ($V_{k-1}$, $V_k$, $V_{k+1}$).

**10.** Dispositif de détection d'un défaut selon la revendication 9 dans lequel les moyens de calcul (42) sont adaptés déterminer la fréquence (f) par approximation polynomiale.

**11.** Dispositif de détection d'un défaut selon l'une des revendications 8 à 10 comprenant en outre des moyens pour communiquer le résultat des moyens de comparaison (46) à un bloc de commande (100).

**12.** Dispositif de détection d'un défaut selon la revendication 11 dans lequel les moyens de stockage (36) sont adaptés pour stocker les premiers paramètres (V) sur une durée prédéfinie de stockage ($T_{stock}$) et les moyens pour communiquer sont adaptés pour les communiquer.

Fig. 1A

Fig. 1B

**Fig. 2A**

**Fig. 2B**

**Fig. 2C**

$V_0$

$V_0^*, f_0$

$T_{ech}$

$V_1$

$V_1^*, f_1 = f_0$

$T_{ech}$

$V_k$

$V_k^*$

$k = k+1$

$V_{k-1}^* > \varepsilon$ ? — N

$V_k^*, f_k = f_{k-1}$

Y

$\delta f_k = F(V_{k-2}^*, V_{k-1}^*, V_k)$ OP

$\delta f_k > S_f$ ? — N

$V_k^*, f_k = f_0 + \delta f_k$

Y

D

36

100

**Fig. 3**

Fig.4

Europäisches
Patentamt

European
Patent Office

Office européen
des brevets

## RAPPORT DE RECHERCHE EUROPEENNE

Numéro de la demande

EP 15 15 2502

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 0 297 418 A1 (ASEA BROWN BOVERI [SE]) 4 janvier 1989 (1989-01-04) * abrégé; revendications 1-2; figures 1,3-5 * * page 2, ligne 1 - page 2, ligne 7 * * page 5, ligne 57 - page 8, ligne 54 * * page 11, ligne 3 - page 12, ligne 40 * | 1-12 | INV. G01R31/02 H02H3/46 G01R23/15 |
| A | WO 03/102605 A1 (TOTALFOERSVARETS FORSKNINGSINS [SE]; BAERNSTROEM KATARINA [SE]) 11 décembre 2003 (2003-12-11) * page 1, ligne 3 - page 1, ligne 28 * * page 3, ligne 28 - page 4, ligne 12 * | 1-12 | |
| A | MUHAMMAD MOHSIN AMAN ET AL: "Modeling and simulation of digital frequency relay for generator protection", POWER AND ENERGY (PECON), 2012 IEEE INTERNATIONAL CONFERENCE ON, IEEE, 2 décembre 2012 (2012-12-02), pages 701-706, XP032327056, DOI: 10.1109/PECON.2012.6450305 ISBN: 978-1-4673-5017-4 * alinéas [0III] - [000A] - alinéas [0III] - [000B]; figures 1-7 * | 1-12 | DOMAINES TECHNIQUES RECHERCHES (IPC) H02H G01R |
| A | EP 1 193 823 A2 (ABB SUBSTATION AUTOMATION OY [FI]) 3 avril 2002 (2002-04-03) * abrégé; revendications 6-7; figures 1-3 * * alinéas [0001], [0003], [0004], [0028] * | 1-12 | |

-/--

Le présent rapport a été établi pour toutes les revendications

| Lieu de la recherche | Date d'achèvement de la recherche | Examinateur |
|---|---|---|
| Munich | 25 juin 2015 | Maric, Viktor |

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 15 15 2502

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 6 519 537 B1 (YANG LIFENG [US]) 11 février 2003 (2003-02-11) * abrégé; figures 1-2 * * colonne 1, ligne 8 - colonne 1, ligne 12 * * colonne 3, ligne 7 - colonne 4, ligne 10 * ----- | 1-12 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| Munich | 25 juin 2015 | Maric, Viktor |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
.......................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**     EP 15 15 2502

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-06-2015

| Document brevet cité au rapport de recherche | | Date de publication | Membre(s) de la famille de brevet(s) | | Date de publication |
|---|---|---|---|---|---|
| EP 0297418 | A1 | 04-01-1989 | EP | 0297418 A1 | 04-01-1989 |
|  |  |  | SE | 458070 B | 20-02-1989 |
| WO 03102605 | A1 | 11-12-2003 | AU | 2003242061 A1 | 19-12-2003 |
|  |  |  | WO | 03102605 A1 | 11-12-2003 |
| EP 1193823 | A2 | 03-04-2002 | EP | 1193823 A2 | 03-04-2002 |
|  |  |  | FI | 20002156 A | 30-03-2002 |
| US 6519537 | B1 | 11-02-2003 | CA | 2347284 A1 | 09-11-2001 |
|  |  |  | MX | PA01004676 A | 10-09-2004 |
|  |  |  | US | 6519537 B1 | 11-02-2003 |

EPO FORM P0460

Pour tout renseignement concernant cette annexe : voir Journal Officiel de l'Office européen des brevets, No.12/82

**EP 2 910 958 A1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1475874 A
- EP 1890165 A
- FR 2936319
- FR 2936378
- WO 2006136520 A
- FR 2713411
- FR 2959618